# EUROPEAN PATENT APPLICATION

(11) **EP 2 627 160 A1**
(43) Date of publication of application: **14.08.2013**
(21) Application number: 12154527.1
(22) Date of filing: 08.02.2012
(51) Int. Cl.: H05K 1/14, H05K 3/34

(54) **Circuit board system**

(71) Applicant: Harman Becker Automotive Systems GmbH, 76307 Karlsbad (DE)
(72) Inventor: Kraft, Günther, 76133 Karlsruhe (DE); Heneka, Eric, 76307 Karlsbad (DE); Ganz, Armin, 76467 Bietigheim (DE); Schroeder, Jürgen, 76337 Waldbronn (DE); Trumpp, Tilo, 75203 Königsbach-Stein (DE)
(74) Representative: Schmuckermaier, Bernhard

(57) **Abstract**

A circuit board system, a circuit board arrangement and a method for producing a circuit board arrangement are disclosed. The system comprises: a first circuit board and a second circuit board (2), each having a top side (11, 21 ) and a bottom side (12, 22); at least one first electronic component (28) mounted on the bottom side of the second circuit board (2). The first circuit board has, on its top side (12), a number of electrically conductive first contact elements (13). The second circuit board (2) has, on its bottom side (22), a number of electrically conductive second contact elements (26). Further, a recess (10) is formed in the first circuit board (1). The second circuit board (2) is mountable on the first circuit board such that the bottom side of the second circuit board (2) faces towards the top side of the first circuit board, that the at least one first electronic component (28) is arranged at least partly in the recess (10); and that each of the first contact elements (26) matches one of the second contact elements (13).

## Description

### BACKGROUND

### 1. Field

Disclosed herein is a circuit board system as can be used, for instance, in an infotainment head unit or in a telematic unit, and a method for producing a circuit board system.

### 2. Related Art

Modular circuit board systems with two or more electrically interconnected circuit boards are becoming more and more popular as the modularity of such arrangements allows to swiftly amend or adapt existing technologies. In many conventional circuit board systems, the connections between individual circuit boards are implemented as plug-in connections. However, plug-in technology is expensive as it requires plugs and sockets. Aside from that, plug and socket technology occupies a lot of space on the circuit boards. On the other hand, if soldered connections are used instead of plug-in technology, the size of the circuit board system is limited by soldering requirements. Moreover, in cases where a bottom side of a circuit board is directly soldered to a carrier circuit board and where the circuit board does not laterally extend beyond the carrier board, the distance between the circuit board and the carrier circuit board is usually too small for mounting electronic components onto the bottom side. Another problem is that many applications require the use of blocking capacitors. However, in conventional circuit board systems, the blocking capacitor(s) often cannot be placed at their ideal location and therefore must be connected via long conductive lines that adversely affect the behavior of the respective circuit. In order to avoid such long conductive lines, a conventional solution has been to mount a blocking capacitor that relates to a circuit substantially formed on a first one of the circuit boards on a second one of the circuit boards instead of on the first circuit board. Thus, the first circuit board cannot be tested independently from the second circuit board.

Hence there is a need for an improved circuit board system.

### SUMMARY OF THE INVENTION

According to a first example, a circuit board system includes: a first circuit board and a second circuit board, each having a top side and a bottom side with at least one first electronic component mounted on the bottom side of the second circuit board; the first circuit board has, on its top side, a number of electrically conductive first contact elements; the second circuit board has, on its bottom side, a number of electrically conductive second contact elements; further, a recess is formed in the first circuit board; the second circuit board is mountable on the first circuit board such that the bottom side of the second circuit board faces towards the top side of the first circuit board, that the at least one first electronic component is arranged at least partly in the recess; and that each of the first contact elements matches one of the second contact elements.

According to a second example, in a circuit board arrangement that includes such a circuit board system, each of the first contact elements is electrically and mechanically connected to one of the second contact elements by soldering. Such a circuit board arrangement may be used, inter alia, in a head unit of an infotainment system or in a telematic unit of an infotainment system.

According to a third example, a method for producing a circuit board includes: providing a circuit board system according to the first example as explained above; electrically and mechanically connecting each of the first contact elements to one of the second contact elements by soldering.

### BRIEF DESCRIPTION OF THE DRAWINGS

Various specific examples are described in more detail below based on the principles illustrated in the figures of the drawings. Unless stated otherwise, similar or identical components are labeled in all of the figures with the same reference numbers.
FIG. 1 is a cross-sectional view of a second circuit board, wherein the bottom side of the second circuit board has both solder balls and at least one electronic component.
FIG. 2 is a bottom view of the second circuit board of FIG. 1.
FIG. 3 is a cross-sectional view of a circuit board arrangement in which the second circuit board of FIGs. 1 and 2 is soldered to a first circuit board such that the at least one electronic component is at least partly arranged in a recess of the first circuit board.
FIG. 4 is a bottom view of the circuit board arrangement of FIG. 3.
FIG. 5 is a cross-sectional view that shows a number of electronic components and a circuit board system with a second circuit board prior to being soldered to a first circuit board.
FIG. 6 is a cross-sectional view of the electronic components and the second circuit board of FIG. 5 after being soldered to the first circuit board.
FIG. 7 is a cross-sectional view of a circuit board arrangement in which the recess is formed bay-like.
FIG. 8 is a bottom view of the circuit board arrangement of FIG. 7.

### DETAILED DESCRIPTION

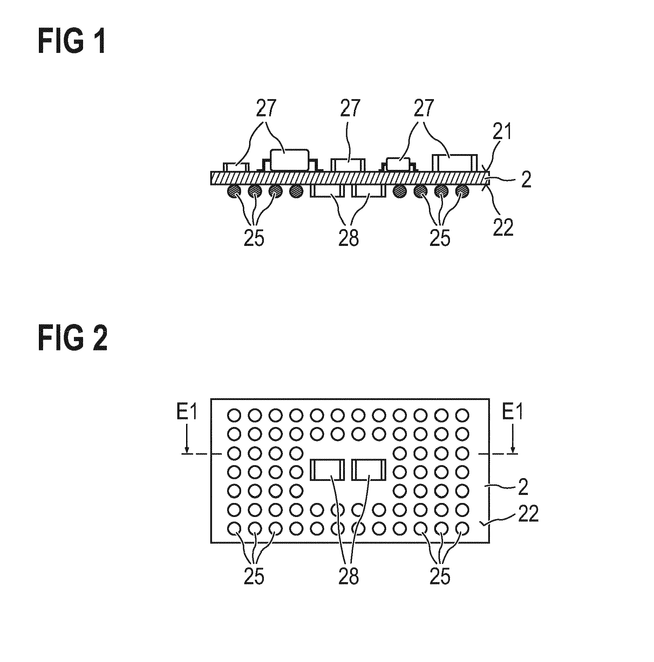

FIG. 1 illustrates a second circuit board 2 having a top side 21 and a bottom side 22 opposite the top side 21. Both the top side 21 and the bottom side 22 may have in conventional manner a top side metallization layer (not illustrated) and a bottom side metallization layer (not illustrated), respectively, that is, flat metal foils which are structured so as to include conductor tracks and/or conductive lands. On the bottom side 22, there is a number of electrically conductive second contact elements comprising solder balls 25. As will be explained in more detail below, the second contact elements allow for soldering the second circuit board 2 to a first circuit board 1. Alternative or in addition to solder balls, some or all of the second contact elements may have lands (metallic pads) formed in the bottom side metallization layer. In addition to the second contact elements, at least one first electronic component 28 is mounted on the bottom side. Optionally, the top side 21 may be equipped with at least one second electronic component 27.

A bottom view of the second circuit board 2 is shown in FIG. 2. In FIG. 2, also a sectional plane E1-E1 of the view of FIG. 1 is marked. As can be seen from FIG. 2 there may be a number of second contact elements each comprising a solder ball 25 arranged in a grid-like manner on the bottom side 22. For instance, in the sense of the present invention such a grid may be a ball grid array (BGA) in case of solder balls 25 or a land grid array (LGA) in case of lands instead of solder balls 25. Such a grid array may have at least 2, at least 3, at least 4 or at least 5 lines and - independently from the number of lines - at least 2, at least 3, at least 4 or at least 5 columns.

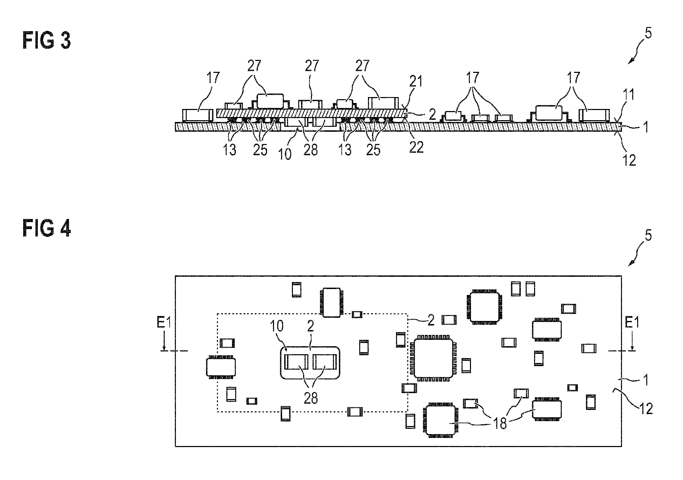

Referring now to FIG. 3, illustrated is a circuit board arrangement 5 in which the second circuit board 2 described above with reference to FIGs. 1 and 2 is soldered with its second contact elements to corresponding first contact elements 13 of a first circuit board 1 that serves as carrier board. The first circuit board 1 has a top side 11 and a bottom side 12 opposite the top side 11. Both the top side 11 and the bottom side 12 may have in conventional manner a top side metallization layer (not illustrated) and a bottom side metallization layer (not illustrated), respectively, that is, flat metal foils which are structured so as to include conductor tracks and/or conductive lands. The bottom side 22 of the second circuit board 2 faces towards the top side 11 of the first circuit board 1.

The first contact elements 13 of the first circuit board 1 may be conductive lands and/or conductive tracks formed in a top side metallization layer of the first circuit board 1. For soldering, the solder balls 25 are melted and subsequently solidified so as to electrically and mechanically connect each of the second contact elements to its corresponding first contact element 13.

As in the soldered state the height of the at least one first electronic component 28 is greater than the distance between the first circuit board 1 and the second circuit board 2, the first circuit board 1 is provided with a recess 10 in which the at least one first electronic component 28 is at least partly arranged. Due to such a recess 10, the bottom side 22 of the second circuit board 2 may also be equipped with one or more electronic components 28. Thanks to this, the flexibility in the design of the second circuit board's 2 layout is improved. For instance, if one of the at least one electronic component 28 is a blocking capacitor, the blocking capacitor may be placed at or close to that location on the second circuit board 2 which is optimum with regard to the blocking effect to be achieved by the blocking capacitor. In order not to waste space of the first circuit board 1, the shape of the recess 10 may be substantially restricted/adapted to the space required for the accommodation of the at least one first electronic component 28. Hence, the recess 10 may have an arbitrary regular or irregular shape.

FIG. 4 is a bottom view of the circuit board arrangement of FIG. 3 in the same sectional plane E1-E1 already illustrated in FIG. 2. As in this view the second circuit board 2 is predominantly hidden behind the first circuit board 1, the position of the second circuit board 2 is indicated with a dashed line. As can be seen from the example of FIGs. 3 and 4, a recess 10 may be a hole that extends completely through the first circuit board 1, i.e., which is - in the plane of the first circuit board 1 - completely surrounded by the first circuit board 1.

As also illustrated in FIG. 3, the top side 11 of the first circuit board 1 may optionally be equipped with at least one third electronic component 17. Irrespective of this, the bottom side 12 of the first circuit board 1 may optionally be equipped with at least one fourth electronic component 18 as illustrated in FIG. 4. In this regard it is noted that in FIG. 3 the optional at least one fourth electronic component 18 exists but is omitted for the sake of clarity.

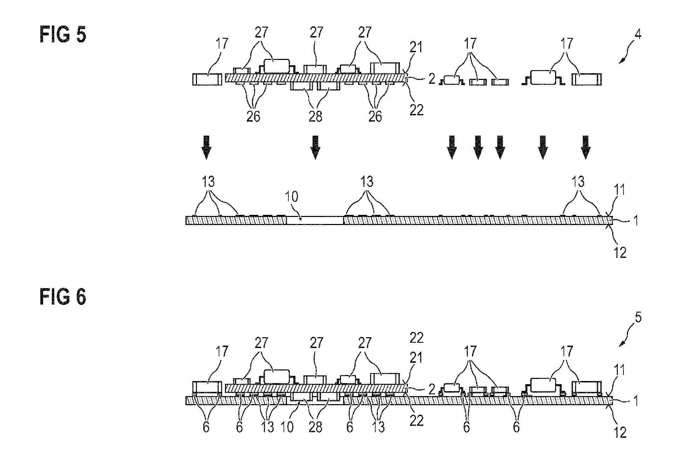

In the examples of FIGs. 1 to 4, the second contact elements were described as including solder balls 25. As is illustrated in FIGs. 5 and 6, second contact elements of a second circuit board 2 may alternatively or additionally include electrically conductive lands 26. Such lands 26 may be formed in a bottom side metallization layer of the second circuit board 2. To the extent that neither a first contact element 13 nor the corresponding second contact element includes a solder ball 25, a solder 6 (FIG. 6) must be applied to at least one of the first contact element 13 and the corresponding second contact element. To this, for instance, the solder 6 may be applied in the form of a solder paste to the respective first contact elements 13. For example, the solder paste 6 may be applied by screen or stencil printing. Subsequently, the second circuit board 2 may be placed on the first circuit board 1 such that the bottom side 22 of the second circuit board 2 faces towards the top side 11 of the first circuit board 1, that the at least one fourth electronic component 18 extends at least partly into the recess 10, and that each of the second contact elements is arranged above the corresponding first contact element 13. Optionally, the solder 6 and third electronic components 17 may be arranged on further first contact elements 13. Afterwards, the first circuit board 1 with the solder 6 disposed on the first contact elements 13 and the second circuit board 2 and, optionally, the third electronic components 17 disposed on the first contact elements 13 and the solder 6 may be placed in a soldering furnace where the second circuit board 2 and the optional third electronic components 17 are soldered to the first circuit board 1. To the extent that a second contact element of the second circuit board 2 includes a solder ball 25, applying an extra solder 6 to the corresponding first contact element 13 is dispensable but possible. FIG. 6 illustrates the completed circuit board arrangement.

As it may be desired to avoid unnecessary soldering cycles for all or at least some of the components of the circuit board arrangement, the second circuit board 2 may be equipped with its components 27, 28 in a first soldering step. Then, the equipped second circuit board 2 may optionally be pre-tested and subsequently be soldered to the first circuit board 1 in a second soldering step in which also the components 17 to be soldered to the top side 11 of the first circuit board 1 are soldered to the first circuit board 1.

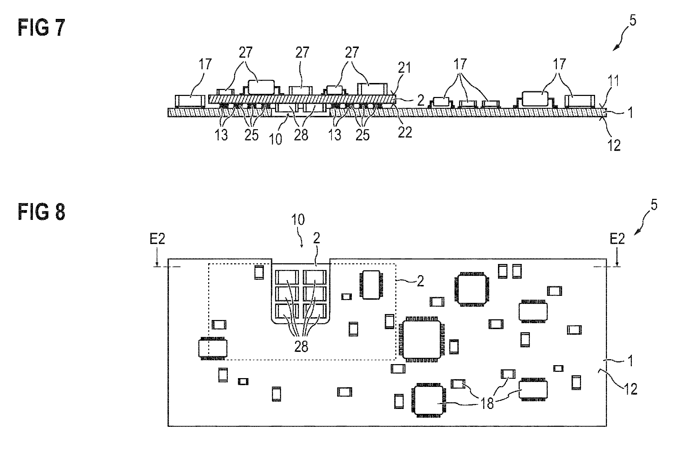

According to a further example illustrated in FIGs. 7 and 8, a recess 10 in which the at least one first electronic component 28 is at least partly arranged may be formed as a bay-like indentation in the first circuit board 1. FIG. 7 is a cross-sectional view of the circuit board arrangement 5 of FIG. 6 in a sectional plane E2-E2. In FIG. 7, an optional one or more fourth electronic component 18 arranged on the bottom side 12 of the first circuit board 1 exists but is omitted for the sake of clarity.

Generally, the present invention includes arrangements in which a second circuit board 2 is soldered on its bottom side 22 to a first circuit board 1, and in which at least one electronic component 28 is arranged on that bottom side 22 and extends at least partly into a recess 10 formed in the first circuit board 1.

Thereby the second circuit board 2 may be arranged completely within the lateral boundary of the first circuit board as illustrated in FIGs. 4 and 8. However, the first and second circuit boards 1, 2 may also only partly overlap.

In the examples described above, the first circuit boards 1 only have a single recess 10. Instead, a first circuit board 1 may include two or more recesses 10 into each of which at least one first electronic component 28 extends at least partly. Thereby, each of the at least one first electronic components 28 is mounted on a second circuit board 2 that is soldered to the first circuit board 1. The at least one first electronic components 28 may be mounted on a common second board or on two or more second circuit boards 2 each of which is soldered to the same first circuit board 1. In case there are two or more second circuit boards 2, different second circuit boards 2 may be arranged on the same side 11 or 12 of the first circuit board 1, or on opposing sides 11, 12.

In any configuration of the present invention, an at least one first electronic component 28 may include a surface mount technology (SMT) component. Such a surface mount technology component may have any possible shape and size, in particular such shapes and sizes as defined in the JEDEC standard. For instance, a first electronic component 28 may be a 0603 component, a 1005 component or a 1608 component (metric system) which correspond to a 0201 component, a 0402 component and a 0603 component, respectively, in the inch system.

Further, the present invention is not limited to first and second circuit boards 1, 2 that have a top side metallization and a bottom side metallization only. The invention also relates to first and second circuit boards 1, 2 which are designed as multilayer boards or which have only one metallization layer. For instance, such a multilayer board may have, for instance, four or eight metallization layers. However, any other number of layers is also applicable.

A circuit board system or arrangement as described above may be used in any arbitrary technical field, for instance in automotive applications like in a head unit of an infotainment system or in a telematic unit. Such a telematic unit may include, for instance, one or - in any combination - some or all of the following functions: emergency call; modem; wireless hot spot; stolen vehicle tracking; global positioning system (GPS).

## Claims

1. A circuit board system comprising:
a first circuit board comprising a top side and a bottom side;
a second circuit board comprising a top side and a bottom side;
at least one first electronic component mounted on the bottom side of the second circuit board; wherein
the first circuit board comprises, on its top side, a number of electrically conductive first contact elements;
the second circuit board comprises, on its bottom side, a number of electrically conductive second contact elements;
the first circuit board comprises a recess;
the second circuit board is mountable on the first circuit board such that
the bottom side of the second circuit board faces towards the top side of the first circuit board; and
the at least one first electronic component is arranged at least partly in the recess; and
each of the first contact elements matches one of the second contact elements.

2. The circuit board system according to claim 1, wherein the number of second contact elements
consist of or comprise solder balls; and/or
consist of or comprise lands.

3. The circuit board system according to claim 2 wherein the number of second contact elements forms a ball grid array or a land grid array having
at least 2, at least 3, at least 4 or at least 5 rows; and
at least 2, at least 3, at least 4 or at least 5 columns.

4. The circuit board system according to one of the preceding claims, wherein the top side of the second circuit board is equipped with at least one second electronic component.

5. The circuit board system according to one of the preceding claims, wherein the at least one first electronic component comprises a surface mount technology component.

6. The circuit board system according to claim 5, wherein the surface mount technology component is a 0603 component, a 1005 component or a 1608 component (metric system).

7. The circuit board system according to one of the preceding claims, wherein the at least one first electronic component comprises a blocking capacitor.

8. The circuit board system according to one of the preceding claims, wherein the recess is a through hole formed in the first circuit board.

9. The circuit board system according to one of the preceding claims, wherein the top side of the first circuit board is equipped with at least one third electronic component.

10. The circuit board system according to one of the preceding claims, wherein each of the first contact elements is electrically and mechanically connected to one of the second contact elements by soldering.

11. The circuit board system according to claim 10 which is an infotainment head unit or a telematic unit comprising of a vehicle.

12. A method for producing a circuit board system comprising:
providing a circuit board system according to one of claims 1 to 8;
electrically and mechanically connecting each of the first contact elements to one of the second contact elements by soldering.

13. The method of claim 12, wherein at least one third electronic component is soldered to the top side of the first circuit board in the same soldering step in which each of the first contact elements is connected to one of the second contact elements.

14. The method of claim 12, wherein at least one third electronic component is soldered to the top side of the first circuit board prior to or after connecting each of the first contact elements to one of the second contact elements by soldering.
